(19) **Europäisches Patentamt / European Patent Office / Office européen des brevets**

(11) **EP 3 084 588 B1**

(12) **FASCICULE DE BREVET EUROPEEN**

(45) Date de publication et mention de la délivrance du brevet:
**25.10.2017 Bulletin 2017/43**

(21) Numéro de dépôt: **14803126.3**

(22) Date de dépôt: **27.11.2014**

(51) Int Cl.:
*G06F 12/02* (2006.01)   *G06K 9/00* (2006.01)
*G06N 3/04* (2006.01)   *G06N 3/063* (2006.01)
*G11C 11/54* (2006.01)

(86) Numéro de dépôt international:
**PCT/EP2014/075729**

(87) Numéro de publication internationale:
**WO 2015/090885 (25.06.2015 Gazette 2015/25)**

(54) **MODULE DE TRAITEMENT DU SIGNAL, NOTAMMENT POUR RESEAU DE NEURONES ET CIRCUIT NEURONAL.**

SIGNALVERARBEITUNGSMODUL, INSBESONDERE FÜR NEURONALES NETZWERK UND NEURONALE SCHALTUNG

SIGNAL PROCESSING MODULE, ESPECIALLY FOR A NEURAL NETWORK AND A NEURONAL CIRCUIT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.12.2013 FR 1362859**

(43) Date de publication de la demande:
**26.10.2016 Bulletin 2016/43**

(73) Titulaire: **Commissariat à l'Énergie Atomique et aux Énergies Alternatives**
**75015 Paris (FR)**

(72) Inventeurs:
• **DURANTON, Marc**
**F-91190 Orsay (FR)**
• **PHILIPPE, Jean-Marc**
**F-91190 Gif-Sur-Yvette (FR)**

(74) Mandataire: **Lucas, Laurent Jacques et al**
**Marks & Clerk France**
**Conseils en Propriété Industrielle**
**Immeuble Visium**
**22, Avenue Aristide Briand**
**94117 Arcueil Cedex (FR)**

(56) Documents cités:
**EP-A1- 0 558 125    EP-A1- 0 694 856**
**WO-A1-91/19259    US-A- 5 023 833**
**US-A- 5 063 521**

# Description

La présente invention concerne un module de traitement du signal, notamment apte à implémenter des algorithmes de type réseaux de neurones. L'invention concerne également un circuit neuronal. Elle s'applique notamment pour l'implémentation de réseaux de neurones sur silicium pour le traitement de signaux divers, y compris des signaux multidimensionnels comme des images par exemple. Elle permet aussi la réalisation efficace de méthodes de traitement du signal conventionnelles.

Les réseaux de neurones sont déjà très utilisés et peuvent potentiellement être utilisés dans de très nombreuses applications, notamment dans tous les dispositifs, systèmes ou procédés faisant appel à des approches ou des mécanismes d'apprentissage servant à définir la fonction à réaliser, contrairement aux approches plus traditionnelles dans lesquelles les actions à effectuer sont définies de façon explicite par un « programme ». Une multitude de systèmes, allant des domaines techniques ou scientifiques les plus sophistiqués jusqu'aux domaines de la vie courante sont ainsi concernés. Toutes ces applications exigent des performances toujours accrues notamment en termes de puissance de calcul pour réaliser des fonctions toujours plus complexes, d'adaptabilité, de taille et de consommation d'énergie. Les algorithmes mis en oeuvre sont essentiels pour atteindre ces performances. L'architecture matérielle permettant d'implémenter ces algorithmes, doit aussi être prise en compte pour l'atteinte des performances, en particulier à un moment où la croissance en fréquence des processeurs stagne ou du moins semble avoir atteint ses limites. En première approximation, on peut classer les architectures matérielles neuronales suivant deux axes :

- Un premier axe concerne leur structure, celle-ci pouvant être numérique ou analogique, voire hybride ;
- Un deuxième axe concerne leur spécialisation vis-à-vis des réseaux de neurones susceptibles d'être implémentés, les architectures pouvant être spécialisées dans quelques réseaux de neurones bien définis, telles que RBF (*Radial-Basis Function*) ou carte de Kohonen, ou pouvant être génériques, notamment programmables pour permettre d'implémenter une plus grande variété de réseaux.

Les types de système adressés par la présente demande de brevet sont liés à des circuits génériques, à implémentation numérique. Les architectures matérielles de systèmes neuronaux comportent en général des modules élémentaires de base aptes à implémenter un ensemble de neurones. De façon connue, un neurone d'ordre i dans un système neuronal réalise une fonction du type :

$$R_i = f\left(\sum_j w_{ij} E_j\right)$$

$w_{ij}$ et $E_j$ étant respectivement les poids synaptiques associés au neurone et ses entrées. Le module élémentaire comporte notamment les unités arithmétiques et logiques (ALU) permettant de réaliser toutes ces fonctions neuronales. f est généralement une fonction non linéaire. Un problème technique à résoudre est notamment d'utiliser efficacement le silicium sur lequel sont implantés les réseaux de neurones, en particulier de permettre une utilisation optimale du stockage des poids et autres données dans la mémoire interne de l'architecture matérielle. Un autre problème est notamment de permettre une réalisation matérielle extensible en nombre de neurones/synapses (et donc d'entrées). Un document EP 0 694 856 A1 divulgue un circuit de chaîne en cascade pour connexions de circuits de neurones.

Un but de l'invention est notamment de pallier les inconvénients précités, à cet effet l'invention a pour objet un module de traitement du signal, comportant au moins une unité opérationnelle incorporant des unités de calcul, des interfaces d'entrée et de sortie aptes à être reliées à un bus et une mémoire stockant des données à destination desdites unités de calcul, ladite mémoire étant organisée de telle sorte que chaque mot de donnée est stocké par colonne sur plusieurs adresses, une colonne ayant une largeur d'un bit, les mots étant transférés en série vers lesdites unités de calcul. Dans un mode de réalisation possible, chaque mot de donnée est stocké par colonne sur plusieurs adresses selon un ordre dépendant de l'application utilisant lesdites données, cet ensemble de plusieurs adresses comporte par exemple des sauts d'adresses.

Les transferts de données s'effectuent par exemple selon une colonne par unité de calcul.

Dans un mode de réalisation possible, le module comporte une unité de routage connectée entre ladite mémoire et l'unité opérationnelle, ladite unité de routage ayant un nombre d'entrées au moins égal au nombre de bits de largeur de ladite mémoire, chaque entrée étant reliée à une colonne et une seule, ladite unité de routage routant les mots de données de ladite mémoire vers les unités de calcul, un même mot pouvant être routé vers plusieurs unités de calcul.

L'unité de routage comporte par exemple au moins deux autres séries d'entrées/sorties aptes à être reliées à des circuits extérieurs audit module. Ces entrées/sorties sont par exemple aptes à être reliées en entrées et sorties de l'unité de routage d'un autre module identique audit module. L'unité de routage effectue par exemple tout ou partie des opérations suivantes :

- décalage des bits des mots de données ;
- opérations logiques ;
- extension des mots.

Le module comporte par exemple une unité de virtualisation de la mémoire reliée d'une part en écriture et en lecture à ladite mémoire et d'autre part à une mémoire externe via un circuit de type DMA.

L'unité de virtualisation de la mémoire effectue par exemple des opérations de réorganisation de ladite mémoire.

Les opérations de réorganisation de ladite mémoire se font par exemple par duplication ou changement d'ordre des données entre les colonnes de ladite mémoire.

Les interfaces d'entrée et de sortie communiquent par exemple avec ledit bus par un protocole TDMA.

Ladite mémoire permet par exemple des accès indépendants en lecture et écriture pour les interfaces d'entrée, l'unité de virtualisation et l'unité de routage.

Avantageusement, le module fonctionne par exemple selon plusieurs zones synchrones indépendantes, l'unité opérationnelle fonctionnant dans un premier domaine d'horloge, les interfaces d'entrée et de sortie fonctionnant dans un second domaine d'horloge.

L'unité de virtualisation de la mémoire fonctionne par exemple dans un troisième domaine d'horloge indépendant.

Les unités de calcul exécutent par exemple les opérations en fonction de la valeur d'un bit de garde affecté à chacune desdites unités.

L'unité opérationnelle comporte par exemple au moins 32 unités de calcul, la ladite mémoire ayant une largeur de 32 bits.

Le module étant apte à implémenter un ensemble de neurones il effectue par exemple des calculs neuronaux ou des traitements numériques du signal, ladite mémoire stockant au moins des résultats des calculs, des coefficients de filtres ou de produits de convolution et des coefficients synaptiques.

L'invention a également pour objet un circuit apte à implémenter un réseau de neurones, caractérisé en ce qu'il comporte au moins une série de modules de traitement du signal apte à implémenter un ensemble de neurones tel que celui décrit précédemment..

Les modules de traitement du signal sont par exemple regroupés par branches, une branche étant formée d'un groupes de modules et d'un bus de diffusion, lesdits modules étant connectés audit bus, un bloc de routage relié aux bus de diffusion desdites branches effectuant au moins le routage et la diffusion des données d'entrée et de sortie dudit circuit vers et depuis lesdites branches.

D'autres caractéristiques et avantages de l'invention apparaîtront à l'aide de la description qui suit faite en regard de dessins annexés qui représentent :

- La figure 1, un exemple de système neuronal comportant une série de modules de traitement élémentaires appelés dans la suite neuro-blocs ;
- La figure 2, le stockage des données (poids synaptiques, entrées, etc.) dans une mémoire ;
- La figure 3, un mode de fonctionnement possible d'un module de traitement du signal selon l'invention ;
- La figure 4, un autre mode de fonctionnement possible d'un module selon l'invention ;
- La figure 5, un exemple de réalisation possible d'un module selon l'invention ;
- La figure 6, un exemple de fonctionnement d'un module selon l'invention avec plusieurs synchronisations indépendantes.

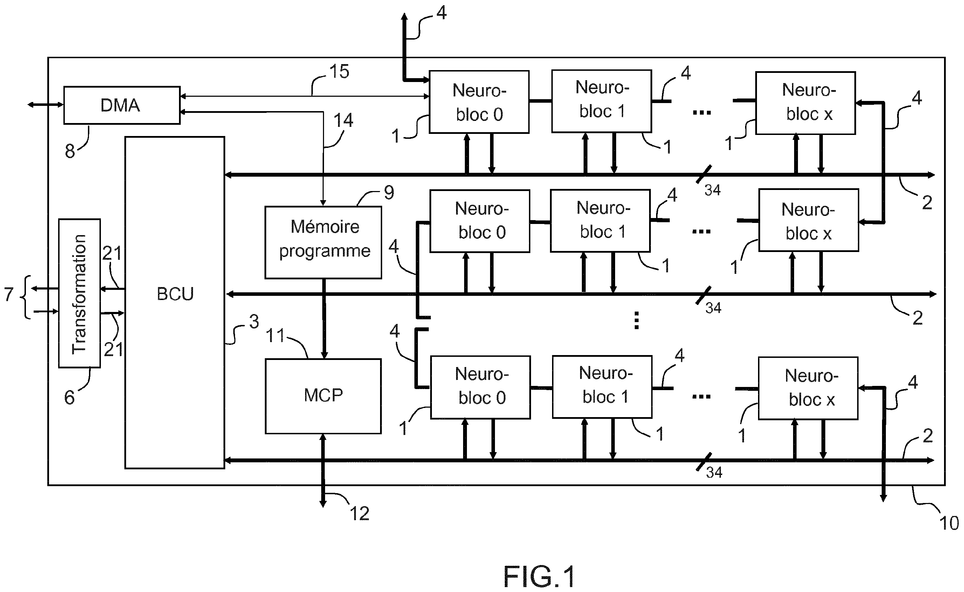

La figure 1 illustre à titre d'exemple un système neuronal comportant une série de neuro-blocs. L'invention est décrite à titre d'exemple pour un module de traitement du signal appliqué aux réseaux de neurones, mais elle peut s'appliquer pour d'autres types de traitements.

Dans l'exemple de la figure 1, le système 10 comporte 32 neuro-blocs 1. Un neuro-bloc peut être considéré comme l'élément de base puisqu'il est apte à implémenter un ensemble de neurones. Comme indiqué précédemment, un neurone d'ordre i réalise une fonction du type :

$$R_i = f(\sum_j w_{ij} E_j)$$

$w_{ij}$ et $E_j$ étant respectivement les poids synaptiques associés au neurone et ses entrées et f étant généralement une fonction non linéaire

Dans l'exemple d'implantation de la figure 1, les neuro-blocs 1 sont répartis par branches. Une branche est composée de plusieurs neuro-blocs 1 et d'un bus de diffusion 2 que partagent les neuro-blocs reliés à ce bus. Dans une configuration à 32 neuro-blocs par exemple, les neuro-blocs peuvent être répartis en 4 branches de 8 neuro-blocs ou en 8 branches de 4 neuro-blocs. D'autre part, tous les neuro-blocs sont par exemple reliés par une ligne d'interconnexion 4 ayant la structure d'un bus chaîné. Plus précisément, les unités arithmétiques et logiques (ALU) de chaque neuro-bloc peuvent être branchées sur ce bus. La ligne d'interconnexion 4 « inter-ALU » traverse ainsi tous les neuro-blocs 1 d'un même circuit 10.

Chaque branche est reliée à un bloc de routage 3, les échanges entre les différentes branches se faisant via ce bloc 3. Ce bloc de routage 3 reçoit par ailleurs des données d'entrée et transmet des données en sortie de circuit par exemple via un module de transformation des données d'entrée/sortie 6. Un module d'accès direct mémoire 8 (DMA) permet une extension de la mémoire disponible. Il est couplé via des bus 14, 15 à une mémoire interne 9, contenant un programme, et peut-être relié à chaque neuro-bloc 1, plus particulièrement à l'unité de gestion mémoire de chaque neuro-bloc. Un module de contrôle 11 fait fonction de processeur de contrôle centralisé.

L'exemple de système neuronal de la figure 1 est utilisé à titre d'exemple pour illustrer un contexte d'utilisation de neuro-blocs. Un module de traitement, ou neuro-bloc, selon l'invention peut bien sûr s'appliquer pour d'autres architectures de systèmes neuronaux.

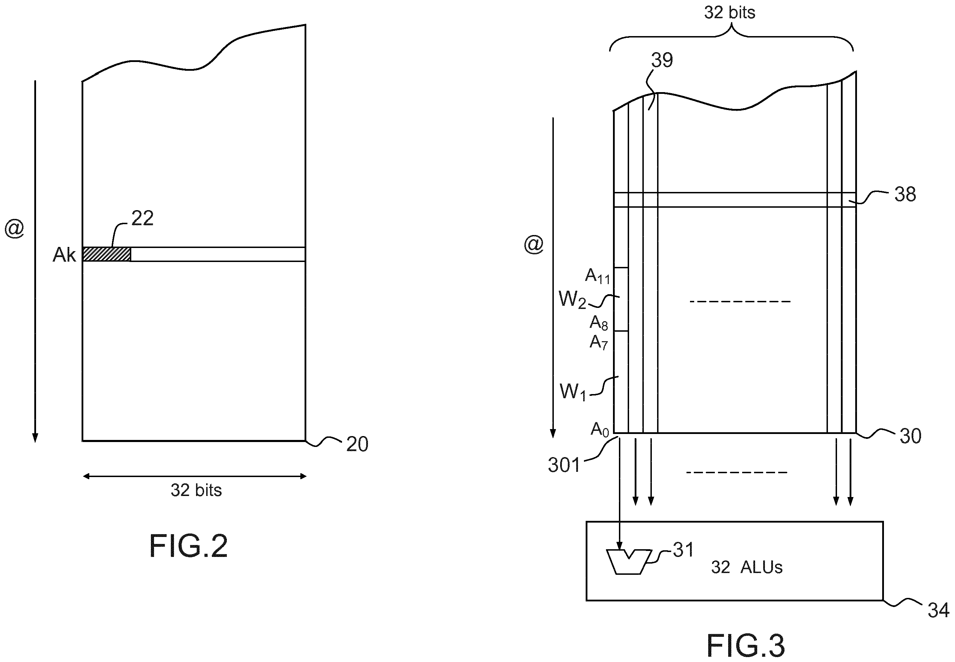

La figure 2 illustre un problème qui se pose pour un module de traitement du signal, notamment du type réseau de neurones. Plus particulièrement, la figure 2 présente une mémoire 20 utilisée dans un neuro-bloc. C'est une mémoire banalisée qui stocke plusieurs types de données. Elle stocke notamment les poids des synapses, des coefficients de filtres de traitement de signal, réalisant notamment des produits de convolution ou des transformées de Fourier, des résultats de calcul finaux ou intermédiaires, ainsi que d'autres données éventuelles.

Un neuro-bloc effectue de très nombreux calculs avec des précisions possiblement variables. Par exemple dans le cas d'un apprentissage en ligne, on peut notamment distinguer la phase d'apprentissage, dans laquelle on calcule les poids synaptiques, nécessitant une grande précision, par exemple sur 16 bits ou 32 bits, et la phase opérationnelle qui nécessite une précision moindre, par exemple sur 8 bits. En tout état de cause, la variabilité des précisions utilisées conduit à effectuer des opérations notamment sur 4 bits, 8 bits, 16 bits ou 32 bits voire plus et même, à l'opposé, sur un seul bit. La figure 2 présente un exemple simple où un mot 22 de 4 bits est stocké dans la mémoire 20 à une adresse donnée, Ak. Dans cette mémoire ayant une largeur de 32 bits, on voit que l'espace est mal occupé. Ce cas illustre une utilisation inefficace du silicium. A titre d'exemple, dans un cas où les adresses de la mémoire 20 sont codées sur 12 bits celle-ci dispose de 4096 adresses. Pour une largeur de 32 bits, elle peut alors contenir 16 kilo-octets, ou plus précisément 16384 octets. Dans les solutions classiques de l'art antérieur, cet espace disponible de 16 kilo-octets est par exemple utilisé à 50%, voire moins si les données ne sont pas des multiples exacts de la largeur de la mémoire.

La figure 3 illustre le mode de fonctionnement d'un neuro-bloc selon l'invention, plus particulièrement la figure 3 illustre le mode de stockage des données dans la mémoire 30 du neuro-bloc et le mode de transfert vers les unités arithmétiques et logiques 31 (ALU). Au lieu de stocker les données par adresses comme dans le cas de la figure 2, elles sont stockées sur plusieurs adresses. L'exemple de la figure 3 illustre un cas préférentiel où les données sont stockées sur un bit par adresse, l'ensemble du mot de donnée étant stocké sur plusieurs adresses successives. Un mot W1 de 8 bits est par exemple stocké sur le premier bit 301 de la mémoire entre les adresses $A_0$ et $A_7$. Un autre mot W2 de 4 bits est par exemple stocké entre les adresses $A_8$ et $A_{11}$. En considérant la mémoire comme un ensemble de lignes 38, correspondant chacune à un adresse, et de colonnes 39, ayant chacune une largeur de un bit, on réalise un remplissage de la mémoire colonne par colonne. En d'autres termes la mémoire est organisée de telle sorte que chaque donnée est stockée par colonne sur plusieurs adresses successives du bit de poids faible vers le bit de poids fort par exemple. Le remplissage est ainsi transposé par rapport à une solution classique où la mémoire est remplie ligne par ligne. Dans l'exemple de la figure 3, les rangs des bits augmentent avec les adresses. L'inverse est possible, l'adresse la plus élevée du mot contenant alors le bit de poids faible. Par ailleurs, les mots sont transférés en série vers une unité de calcul opérationnelle 34, par exemple constituée d'un ensemble d'ALU 31. Un mot de donnée est ainsi repéré selon le rang qu'il occupe en largeur et les adresses qu'il occupe en colonne. Le mot W2 occupe ainsi le premier bit entre les adresses $A_8$ et $A_{11}$. Le remplissage transposé de la mémoire tel que décrit précédemment combiné au transfert série des données permet d'optimiser l'espace mémoire disponible.

La structure de stockage d'un module selon l'invention, tel qu'illustré par la figure 3 apporte un autre avantage. Elle permet notamment d'accélérer certains calculs. En raison du stockage de type « série » à l'intérieur de la mémoire, on peut lire un mot dans un sens ou dans l'autre. Plus précisément, les données peuvent être transférées vers les unités de calcul en partant du bit de poids faible, LSB (Least Significant Bit), ou en partant du bit du poids fort, MSB (Most Significant Bit). Selon les opérations, on peut choisir un transfert dans un sens plutôt que dans l'autre. Ainsi pour un calcul du maximum entre deux nombres binaires, il est avantageux au point de vue de la rapidité de calcul d'effectuer un transfert à partir du MSB, les comparaisons commençant par le bit de poids fort. En effet, si la première donnée a son MSB à 0 et la deuxième son MSB à 1, l'unité de calcul peut immédiatement conclure que la deuxième donnée est la plus grande des deux si les codages sont en non signé. A contrario, pour une addition, il est plus avantageux de commencer le transfert par le LSB, pour la propagation de la retenue.

La figure 3 illustre un mode de réalisation où les bits sont transférés directement aux ALU 31, les transferts s'effectuant une colonne par ALU par exemple. Dans le cas d'une application à 32 ALU avec une largeur de mémoire de 32 bits, un rang de bit est affecté à chaque ALU.

Dans l'exemple de la figure 3, les mots sont stockés sur plusieurs adresses successives selon un ordre croissant. Elles peuvent bien sûr être stockées selon un ordre décroissant ou en désordre si besoin. Par ailleurs, les adresses de stockages ne sont pas nécessairement successives, il peut en effet y avoir des sauts d'adresses. En fait, l'ordre et la succession dépendent notamment de l'application.

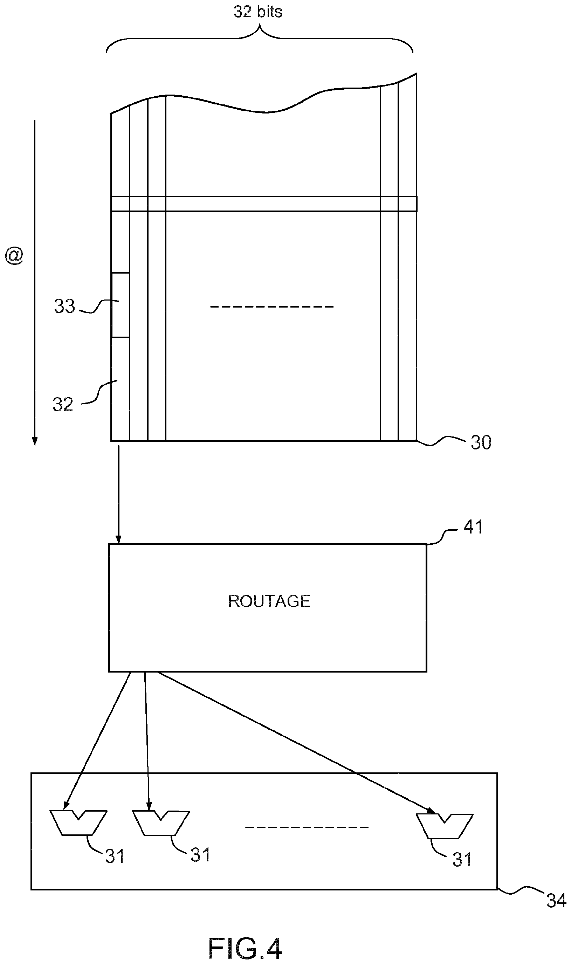

La figure 4 présente un mode de réalisation plus optimal où les mots série sont transférés via une unité de routage 41. Cette unité de routage permet d'améliorer encore l'utilisation de l'espace mémoire. Cette unité permet notamment de router, ou diffuser, un mot de donnée vers un ou plusieurs circuits, en particulier vers une ou plusieurs ALU 31. Ainsi par exemple, un poids synaptique stocké dans la mémoire 30 peut être transféré vers plusieurs ALU 31 formant chacune une unité de calcul. En particulier les filtres, les produits de convolution ou d'autres types d'opérations propres aux réseaux de neurones, ont en commun des données. En d'autres termes, ces données sont partagées entre plusieurs opérations, par exemple, un même filtre est utilisé sur plusieurs pixels d'une même image dans une opération de convolution. En l'absence de l'unité de routage 41, le poids synaptique précité devrait être stocké en plusieurs endroits de la mémoire (par exemple sur chaque colonne) afin d'être transféré vers les ALU qui en ont besoin. La diffusion opérée par l'unité de routage évite ainsi des recopies ou des affectations multiples dans la mémoire 30, une donnée partagée pouvant être stockée en un seul endroit de la mémoire.

A côté de la fonction de diffusion décrite précédemment, l'unité de routage 41 peut réaliser d'autres fonctions. Cette unité 41 peut par exemple effectuer également les opérations suivantes :

- Décalage des bits des mots de données (dans un sens ou dans l'autre) ; par exemple pour faciliter le calcul dit de fenêtres glissantes.
- Opérations logiques ;
- Extension des mots selon différentes échelles en insérant par exemple un ou plusieurs « 0 » entre tous les bits d'un mot.

L'unité de routage 41 est par exemple composée de multiplexeurs, de registres et portes logiques afin de réaliser les différentes opérations de routage et de transformation des données. Ces éléments sont agencés, de façon connue, de telle sorte que les opérations de routage et de transformation, entre la mémoire 30 et l'unité opérationnelle 34, puissent être réalisées en un seul cycle.

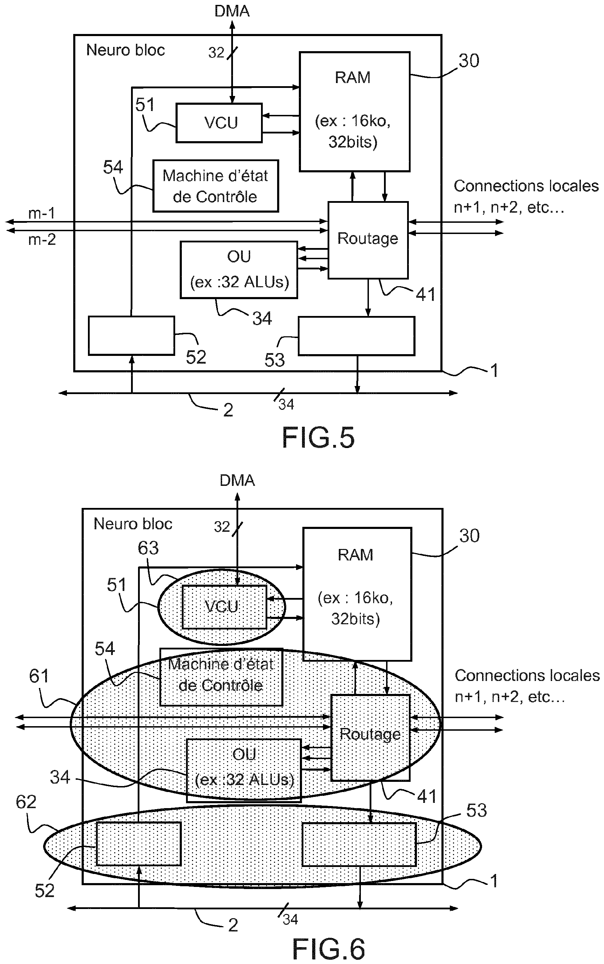

La figure 5 présente un exemple de réalisation possible d'un module de traitement du signal selon l'invention. Le module comporte une mémoire 30, une unité de routage 41 et une unité opérationnelle 34 agencées et fonctionnant conformément à la description de la figure 4.

La mémoire 30 est par exemple une mémoire du type RAM ayant une capacité de 16 kilo-octets pour une largeur de 32 bits. Comme indiqué précédemment, elle est notamment destinée à stocker diverses données telle que les données d'entrées, les résultats, les résultats intermédiaires, les coefficients de filtres ou de produits de convolution pour le prétraitement ainsi que les coefficients synaptiques.

Comme dans les exemples précédents, l'unité opérationnelle 34 comporte 32 ALU. Elle réalise tous les calculs requis à l'intérieur du neuro-bloc, en particulier pour effectuer à la fois des prétraitements et des traitements neuronaux. Les opérations qui peuvent être implémentées sont par exemple les suivantes :

- Addition et soustraction ;

- Multiplication et division ;
- Calcul de minimum et de maximum ;
- Calcul numérique par rotation de coordonnée (CORDIC) pour des fonctions trigonométriques ou hyperboliques.

Les ALU peuvent opérer sur des opérandes provenant de différentes sources. Une première source de données est bien sûr la mémoire 30, via l'unité de routage 41. Les opérandes peuvent également provenir d'autres modules 1 lorsque le module est implémenté dans un système, par exemple un système neuronal du type de la figure 1. Les transferts entre les modules peuvent se faire par exemple par l'unité de routage 41. Cette dernière effectue par exemple dans le module de rang n une interconnexion locale avec les modules voisins, par exemple avec les modules de rang n-2, n-1, n+1 et n+2.

Le module 1 est par ailleurs apte à être connecté à un bus externe 2, par exemple du type du bus de diffusion du système neuronal de la figure 1, via des interfaces d'entrée et de sortie 52, 53 qui seront décrites par la suite.

Le neuro-bloc comporte par exemple une unité 51 de virtualisation de la mémoire et de gestion de la topologie des réseaux de neurones (VCU) permettant la virtualisation de la mémoire du neuro-bloc et l'implémentation des différentes topologies de réseaux de neurones. Cette unité 51 dispose d'un accès direct et indépendant à la mémoire 30, en lecture et en écriture. L'unité VCU 51 peut également assurer la connectivité globale entre les ALU 34. A cet effet, elle possède un certain nombre d'opérateurs permettant de réorganiser les données stockées en mémoire 30, par duplication ou changement d'ordre par exemple (lecture d'une donnée et écriture à une autre adresse). Elle permet aussi de réorganiser les données en mémoire, par exemple de remplacer des données qui ne sont plus utiles par des données utiles, permettant par exemple, à l'unité de routage et l'ensemble d'alu 34 de faire la même séquence d'opérations avec les mêmes adresses d'opérandes dans la mémoire 30, mais avec des nouvelles données utiles. Les données ainsi réorganisées sont prêtes à être utilisées par l'unité de routage 41 et l'unité opérationnelle 34. L'unité VCU 51 est par ailleurs reliée à un module à accès direct mémoire (DMA) extérieur au neuro-bloc via un bus 32 bits par exemple. Elle peut ainsi lire des blocs entiers dans la mémoire 30 pour les envoyer vers une mémoire externe ou écrire des blocs entiers dans la mémoire 30 venant d'une mémoire externe. L'unité VCU 51 permet ainsi de virtualiser la mémoire contenant les poids synaptiques, elle permet en fait une virtualisation des poids synaptiques à l'extérieur du neuro-bloc.

Le neuro bloc 1 comporte par exemple un module d'entrée 52 et un module de sortie 53 permettant la connexion du neuro-bloc au bus de diffusion. En particulier, ils gèrent l'asynchronisme (ou en tout cas l'absence de synchronisation) entre les différents modules reliés via le bus de diffusion 2. Dans le cas d'application de la figure 1, les différents modules sont notamment les autres neuro-blocs et, dans une implémentation silicium, le fait de ne pas forcer la synchronisation des neuro-blocs (c'est-à-dire ne pas avoir un circuit entièrement synchrone) permettra de gagner en fréquence de fonctionnement et de simplifier la réalisation modulaire indépendamment du nombre de neuro-blocs.

Le module d'entrée 52 possède une adresse unique propre au neuro-bloc mais possiblement ré-assignable. Il surveille notamment les mots de contrôle des messages transitant sur le bus de diffusion : si l'identifiant de neuro-bloc situé dans l'en-tête du message (Neuro-bloc ID) correspond à la propre adresse du module d'entrée 52 ou si cet identifiant correspond à une opération de diffusion, le module capture l'ensemble des données du message et les stocke dans la mémoire 30 à des adresses préalablement données par le programme interne du neuro-bloc selon le mode d'adressage décrit relativement à la figure 3. Le module de sortie 53 est équipé par exemple d'une mémoire en FIFO qui gère l'attente du fait du protocole TDMA, si celui-ci est par exemple utilisé pour accéder notamment au bus de diffusion. Selon le type de donnée, le module 53 peut générer un flit de contrôle. Il stocke localement n séquences de 32 bits par exemple avant de les envoyer sur le bus de diffusion, selon le protocole utilisé. Avantageusement, le protocole TDMA peut être combiné avec l'utilisation de la mémoire 30 par les différentes ressources 51, 41, 52. En effet, d'une part le protocole TDMA permet de diviser le temps en créneaux, chaque module interne au neuro-bloc ayant un créneau dédié (par exemple, un premier créneau de temps étant réservé au VCU 51, un deuxième aux système de routage 41 relié aux ALU 34, un troisième au module d'entrée 52, etc.).

Un bloc 54, par exemple un contrôleur SIMD (Single Instruction Multiple Data) à 32 voies, effectue le contrôle des transferts à l'intérieur du neuro-bloc selon un processus classique, connu de l'homme du métier. De plus, chaque ALU 31 composant le bloc 34 est par exemple contrôlée par un bit de garde, dont l'état dépend des données à traiter. Ce bit de garde peut aussi être contrôlé par le bloc 54. Ce bit de garde permet une exécution conditionnelle des opérations par les ALU 31, une ALU exécutant ou non une opération envoyée par le bloc 54 en fonction de la valeur du bit de garde (ce bit de garde permettant de ne pas tenir compte du résultat de l'opération si besoin par exemple).

La figure 6 illustre les différents domaines de synchronisation, ou domaines d'horloge, à l'intérieur d'un neuro-bloc. Ces différents domaines de synchronisation 61, 62, 63 caractérisent le découplage des calculs, des communications « longue distance » et de la virtualisation. En d'autres termes une première fréquence de synchronisation 61 cadence les calculs effectués par l'unité opérationnelle 34, une deuxième fréquence de synchronisation 62 cadence les communications vers le bus de diffusion via les modules d'entrées/sortie 52, 53 et une troisième fréquence de synchronisation 63 cadence le fonctionnement de l'unité 51 de virtualisation de la mémoire. Ces trois domaines de synchronisation sont indépendants et les fréquences de synchronisation peuvent varier dans le temps, par exemple pour s'adapter à la vitesse de traitement appropriée à chaque domaine au cours du temps.

Un module selon l'invention permet notamment une implémentation efficace des traitements et réseaux sur silicium. L'architecture série à l'intérieur du module et l'organisation du stockage dans la mémoire 30 permet une précision variable au bit près tout en optimisant la place mémoire occupée ainsi que le temps de calcul. L'invention permet ainsi d'utiliser toutes les ressources de mémorisation.

Le découplage apporté par les différents domaines de synchronisation apporte notamment les avantages suivant : augmentation de la fréquence de fonctionnement du circuit lors de l'implémentation, variation possible des fréquences de fonctionnement des neuro-blocs de manière indépendante pour optimiser la consommation énergétique, etc. Et elle permet de découpler la programmation des différentes parties dans les différents domaines de synchronisation, facilitant ainsi le développement d'applications et la scalabilité de l'architecture proposée suivant les différentes réalisations possibles (variation du nombre de neuro-blocs, de la réalisation des protocoles de communication des unités 52 et 53 etc.).

## Revendications

1. Module de traitement du signal, comportant au moins une unité opérationnelle (34) incorporant des unités de calcul (31), des interfaces d'entrée et de sortie (52, 53) aptes à être reliées à un bus et une mémoire (30) stockant des données à destination desdites unités de calcul, **caractérisé en ce que** ladite mémoire (30) est organisée de telle sorte que chaque mot de donnée est stocké par colonne (39) sur plusieurs adresses, une colonne ayant une largeur d'un bit, les mots étant transférés en série vers lesdites unités de calcul (31).

2. Module de traitement du signal selon la revendication 1, **caractérisé en ce que** chaque mot de donnée est stocké par colonne (39) sur plusieurs adresses selon un ordre dépendant de l'application utilisant lesdites données.

3. Module de traitement du signal selon la revendication 2, **caractérisé en ce que** lesdites plusieurs adresses comportent des sauts d'adresses.

4. Module de traitement du signal selon l'une quelconque des revendications précédentes, **caractérisé en ce que** les transferts de données s'effectuent une colonne (39) par unité de calcul (31).

**5.** Module du traitement du signal selon l'une quelconque des revendications précédentes, **caractérisé en ce qu'**il comporte une unité de routage (41) connectée entre ladite mémoire (30) et l'unité opérationnelle (34), ladite unité de routage ayant un nombre d'entrées au moins égal au nombre de bits de largeur de ladite mémoire (30), chaque entrée étant reliée à une colonne et une seule, ladite unité de routage routant les mots de données de ladite mémoire vers les unités de calcul (31), un même mot pouvant être routé vers plusieurs unités de calcul (31).

**6.** Module de traitement du signal selon la revendication 5, **caractérisé en ce que** l'unité de routage comporte au moins deux autres séries d'entrées/sorties aptes à être reliées à des circuits extérieurs audit module (1).

**7.** Module de traitement du signal selon la revendication 6, **caractérisé en ce que** lesdites entrées/sorties sont aptes à être reliées en entrées et sorties de l'unité de routage d'un autre module identique audit module (1).

**8.** Module de traitement du signal selon l'une quelconque des revendications 5 à 7, **caractérisé en ce que** l'unité de routage (41) effectue tout ou partie des opérations suivantes :

- décalage des bits des mots de données ;
- opérations logiques ;
- extension des mots.

**9.** Module de traitement du signal selon l'une quelconque des revendications précédentes, **caractérisé en ce qu'**il comporte une unité (51) de virtualisation de la mémoire reliée d'une part en écriture et en lecture à ladite mémoire (30) et d'autre part à une mémoire externe via un circuit de type DMA.

**10.** Module de traitement du signal selon la revendication 8, **caractérisé en ce que** l'unité (51) de virtualisation de la mémoire effectue des opérations de réorganisation de ladite mémoire (30).

**11.** Module de traitement du signal selon la revendication 9, **caractérisé en ce que** les opérations de réorganisation de ladite mémoire (30) se font par duplication ou changement d'ordre des données entre les colonnes (39) de ladite mémoire (30).

**12.** Module de traitement du signal selon l'une quelconque des revendications précédentes, **caractérisé en ce qu'**il fonctionne selon plusieurs zones synchrones indépendantes (61, 62, 63), l'unité opérationnelle (34) fonctionnant dans un premier domaine d'horloge (61), les interfaces d'entrée (52) et de sortie (53) fonctionnant dans un second domaine d'horloge (62).

**13.** Module de traitement du signal selon la revendication 12 et l'une quelconque des revendications 7 à 11, **caractérisé en ce que** l'unité (51) de virtualisation de la mémoire fonctionne dans un troisième domaine d'horloge indépendant (63).

**14.** Module de traitement du signal selon l'une quelconque des revendications précédentes, **caractérisé en ce que** les unités de calcul (31) exécutent les opérations en fonction de la valeur d'un bit de garde affecté à chacune desdites unités (31).

**15.** Module de traitement du signal selon l'une quelconque des revendications précédentes, **caractérisé en ce qu'**étant apte à implémenter un ensemble de neurones il effectue des calculs neuronaux ou des traitements numérique du signal, ladite mémoire stockant au moins des résultats des calculs, des coefficients de filtres ou de produits de convolution et des coefficients synaptiques.

**16.** Circuit apte à implémenter un réseau de neurones, **caractérisé en ce qu'**il comporte au moins une série de modules de traitement du signal (1) selon la revendication 15.

**17.** Circuit selon la revendication 16, **caractérisé en ce que** les modules de traitement du signal (1) sont regroupés par branches, une branche étant formée d'un groupes de modules (1) et d'un bus de diffusion (2), lesdits modules (1) étant connectés audit bus (2), un bloc de routage (3) relié aux bus de diffusion desdites branches effectuant au moins le routage et la diffusion des données d'entrée et de sortie dudit circuit vers et depuis lesdites branches.

**Patentansprüche**

**1.** Signalverarbeitungsmodul, umfassend mindestens eine Betriebseinheit (34), die Recheneinheiten (31), Eingangs- und Ausgangsschnittstellen (52, 53), verbindbar mit einem Bus und einem Speicher (30), der Daten speichert, die für die Recheneinheiten bestimmt sind, beinhaltet, **dadurch gekennzeichnet, dass** der Speicher (30) derart organisiert ist, dass jedes Datenwort je Spalte (39) über mehrere Adressen gespeichert wird, wobei eine Spalte eine Breite von einem Bit aufweist, wobei die Wörter in Reihe an die Recheneinheiten (31) übertragen werden.

**2.** Signalverarbeitungsmodul nach Anspruch 1, **dadurch gekennzeichnet, dass** jedes Datenwort je Spalte (39) über mehrere Adressen gemäß einer Ordnung, die von der Anwendung abhängt, die diese Daten verwendet, gespeichert wird.

**3.** Signalverarbeitungsmodul nach Anspruch 2, **dadurch gekennzeichnet, dass** die mehreren Adressen Adressensprünge umfassen.

**4.** Signalverarbeitungsmodul nach einem der vorhergehenden Ansprüche, **dadurch gekennzeichnet, dass** die Datenübertragungen in Form von einer Spalte (39) pro Recheneinheit (31) durchgeführt werden.

**5.** Signalverarbeitungsmodul nach einem der vorhergehenden Ansprüche, **dadurch gekennzeichnet, dass** es eine Routing-Einheit (41) umfasst, die zwischen dem Speicher (30) und der Betriebseinheit (34) verbunden ist, wobei die Routing-Einheit eine Anzahl von Eingängen aufweist, die zumindest gleich der Anzahl von Breiten-Bits des Speichers (30) ist, wobei jeder Eingang mit einer einzigen Spalte verbunden ist, wobei die Routing-Einheit die Datenwörter von dem Speicher zu den Recheneinheiten (31) leitet, wobei dasselbe Wort zu mehreren Recheneinheiten (31) geleitet werden kann.

**6.** Signalverarbeitungsmodul nach Anspruch 5, **dadurch gekennzeichnet, dass** die Routing-Einheit mindestens zwei weitere Reihen an Eingängen/Ausgängen umfasst, die mit Schaltungen außerhalb des Moduls (1) verbindbar sind.

**7.** Signalverarbeitungsmodul nach Anspruch 6, **dadurch gekennzeichnet, dass** die Eingänge/Ausgänge als Eingänge und Ausgänge der Routing-Einheit eines anderen Moduls, das mit dem Modul (1) identisch ist, verbindbar sind.

**8.** Signalverarbeitungsmodul nach einem der Ansprüche 5 bis 7, **dadurch gekennzeichnet, dass** die Routing-Einheit (41) alle der folgenden Operationen oder einen Teil davon ausführt:

  - Verschieben der Bits der Datenwörter;
  - logische Operationen;
  - Erweiterung der Wörter.

**9.** Signalverarbeitungsmodul nach einem der vorhergehenden Ansprüche, **dadurch gekennzeichnet, dass** es eine Einheit (51) zur Speichervirtualisierung umfasst, die einerseits im Schreib- und Lesemodus mit dem Speicher (30) und andererseits über eine Schaltung des Typs DMA mit einem externen Speicher verbunden ist.

**10.** Signalverarbeitungsmodul nach Anspruch 8, **dadurch gekennzeichnet, dass** die Einheit (51) zur Speichervirtualisierung Operationen zum Umorganisieren des Speichers (30) durchführt.

**11.** Signalverarbeitungsmodul nach Anspruch 9, **da-**

**durch gekennzeichnet, dass** die Operationen zum Umorganisieren des Speichers (30) durch Vervielfältigung oder Änderung der Ordnung der Daten zwischen den Spalten (39) des Speichers (30) erfolgen.

**12.** Signalverarbeitungsmodul nach einem der vorhergehenden Ansprüche, **dadurch gekennzeichnet, dass** es gemäß mehreren unabhängigen synchronen Zonen (61, 62, 63) arbeitet, wobei die Betriebseinheit (34) in einem ersten Taktbereich (61) arbeitet, die Eingangsschnittstelle (52) und die Ausgangsschnittstelle (53) in einem zweiten Taktbereich (62) arbeiten.

**13.** Signalverarbeitungsmodul nach Anspruch 12 und einem der Ansprüche 7 bis 11, **dadurch gekennzeichnet, dass** die Einheit (51) zur Speichervirtualisierung in einem dritten unabhängigen Taktbereich (63) arbeitet.

**14.** Signalverarbeitungsmodul nach einem der vorhergehenden Ansprüche, **dadurch gekennzeichnet, dass** die Recheneinheiten (31) die Operationen in Ahängigkeit von dem Wert eines Schutzbits, das jeder der Einheiten (31) zugewiesen ist, ausführen.

**15.** Signalverarbeitungsmodul nach einem der vorhergehenden Ansprüche, **dadurch gekennzeichnet, dass** es, da es dazu fähig ist, einen Satz an Neuronen zu implementieren, neuronale Berechnungen oder Signaldigitalverarbeitungen durchführt, wobei der Speicher mindestens Ergebnisse der Berechnungen, Koeffizienten von Filtern oder von Faltungsprodukten und synaptische Koeffizienten speichert.

**16.** Schaltung, die dazu fähig ist, ein neuronales Netzwerk zu implementieren, **dadurch gekennzeichnet, dass** sie mindestens eine Reihe an Signalverarbeitungsmodulen (1) nach Anspruch 15 umfasst.

**17.** Schaltung nach Anspruch 16, **dadurch gekennzeichnet, dass** die Signalverarbeitungsmodule (1) in Zweigen gruppiert sind, wobei ein Zweig aus einer Gruppe an Modulen (1) und einem Verbreitungsbus (2) gebildet wird, wobei die Module (1) mit dem Bus (2) verbunden sind, wobei ein Routing-Block (3), der mit den Verbreitungsbussen der Zweige verbunden ist, mindestens das Leiten und Verbreiten der Eingangs- und Ausgangsdaten der Schaltung zu und von den Zweiten durchführt.

**Claims**

**1.** Signal processing module comprising at least one operational unit (34) incorporating calculation units (31), input and output interfaces (52, 53) able to be connected to a bus and a memory (30) storing data which are intended for said calculation units, **characterised in that** said memory (30) is organized in such a manner that each data word is stored by column (39) over a plurality of addresses, a column having a width of one bit, the words being transferred in series to said calculation units (31).

2. Signal processing module according to claim 1, **characterised in that** each data word is stored by column (39) over a plurality of addresses according to an order dependent on the application using said data.

3. Signal processing module according to claim 2, **characterised in that** said plurality of addresses comprise address jumps.

4. Signal processing module according to any one of the preceding claims, **characterised in that** the data transfers are performed in accordance with one column (39) per calculation unit (31).

5. Signal processing module according to any one of the preceding claims, **characterised in that** it comprises a routing unit (41) connected between said memory (30) and the operational unit (34), said routing unit having a number of inputs at least equal to the number of width bits of said memory (30), each input being connected to a single column only, said routing unit routing the data words from said memory to the calculation units (31), the same word being able to be routed to a plurality of calculation units (31).

6. Signal processing module according to claim 5, **characterised in that** the routing unit comprises at least two other series of inputs/outputs able to be connected to circuits outside the module (1).

7. Signal processing module according to claim 6, **characterised in that** said inputs/outputs are able to be connected as inputs and outputs of the routing unit of another module identical to the module (1).

8. Signal processing module according to any one of claims 5 to 7, **characterised in that** the routing unit (41) performs all or some of the following operations:

   - shifting of the bits of the data words;
   - logical operations;
   - expansion of the words.

9. Signal processing module according to any one of the preceding claims, **characterised in that** it comprises a memory virtualization unit (51) connected, on the one hand, in terms of writing and reading to said memory (30) and, on the other hand, to an external memory via a circuit of DMA type.

10. Signal processing module according to claim 8, **characterised in that** the memory virtualization unit (51) performs operations of reorganization of said memory (30).

11. Signal processing module according to claim 9, **characterised in that** the operations of reorganization of said memory (30) are carried out by duplication or change of order of the data between the columns (39) of said memory (30).

12. Signal processing module according to any one of the preceding claims, **characterised in that** it operates in accordance with a plurality of independent synchronous zones (61, 62, 63), the operational unit (34) operating in a first clock range (61), the input interface (52) and the output interface (53) operating in a second clock range (62).

13. Signal processing module according to claim 12 and any one of claims 7 to 11, **characterised in that** the memory virtualization unit (51) operates in a third independent clock range (63).

14. Signal processing module according to any one of the preceding claims, **characterised in that** the calculation units (31) execute the operations as a function of the value of a guard bit assigned to each of said units (31).

15. Signal processing module according to any one of the preceding claims, **characterised in that**, being able to implement a set of neurons, it performs neuronal calculations or digital processing operations of the signal, said memory storing at least results of the calculations, coefficients of filters or of convolution products and synaptic coefficients.

16. Circuit able to implement a neural network, **characterised in that** it comprises at least one series of signal processing modules (1) according to claim 15.

17. Circuit according to claim 16, **characterised in that** the signal processing modules (1) are grouped together as branches, a branch being formed by a group of modules (1) and a dissemination bus (2), said modules (1) being connected to said bus (2), a routing block (3) connected to the dissemination buses of said branches performing at least the routing and the dissemination of the input and output data of said circuit to and from said branches.

FIG.1

EP 3 084 588 B1

FIG.2

FIG.3

EP 3 084 588 B1

32 bits

@

33

32

30

41

ROUTAGE

31    31    31

34

FIG.4

FIG.5

FIG.6

**EP 3 084 588 B1**

## RÉFÉRENCES CITÉES DANS LA DESCRIPTION

**Documents brevets cités dans la description**

- EP 0694856 A1